# EUROPEAN PATENT APPLICATION

(11) **EP 1 518 899 A2**
(43) Date of publication of application: **30.03.2005**
(21) Application number: 04019993.7
(22) Date of filing: 23.08.2004
(51) Int. Cl.: C08L 63/00, C08L 71/02, C08G 65/18, G11B 7/26

(54) **Photocurable adhesive and bonding process employing same**

(30) Priority: 18.09.2003 JP 2003325400
(71) Applicant: Fuji Photo Film Co., Ltd., Minamiashigara-shi Kanagawa (JP)
(72) Inventor: Hosaka, Shunichi, Minamiashigara-shi Kanagawa (JP)
(74) Representative: Albrecht, Thomas, Dr.

(57) **Abstract**

An actinic radiation curable adhesive is provided that includes 50 to 99 wt % of a bifunctional and/or a polyfunctional oxetane compound, 0 to 40 wt % of a monofunctional oxetane compound, 1 to 50 wt % of an epoxy compound having a cyclic structure, and a catalytic amount of a photoinitiator. The adhesive has an initial viscosity of 10 to 1,000 mPa·s and a viscosity at gel point of 1 × 10¹ to 9 × 10⁶ Pa.s. There is also provided a process for bonding an adherend A and a different adherend B, the process including forming an adhesive layer by coating a surface of the adherend A with the above adhesive at a thickness of 0.05 to 50 µm, irradiating the adhesive layer with actinic radiation, and bonding the adherend B to the adhesive layer after 0.01 to 4 times the time required for gelling of the adhesive layer has passed following the start of irradiation with actinic radiation.

## Description

The present invention relates to a photocurable adhesive and a bonding process employing same, the adhesive being capable of bonding a light-opaque member.

DVD (Digital Video/Versatile Disc) photorecording media are produced by bonding together two members. For this bonding, since it is necessary to align the two members, UV curable adhesives having a relatively slow cure rate are used (ref. JP-A-2001-256677 (JP-A denotes a Japanese unexamined patent application publication)).

These so-called slow-curing photocurable adhesives employ a cationically photopolymerizable composition; the composition is applied to one adherend, this composition is irradiated with UV rays so as to initiate a curing reaction, another, different adherend is superimposed on this composition while it is still in a liquid state, and the adherends are held under pressure, thus completing bonding. The cationic polymerization reaction initiated by irradiation with light has so-called living properties, and continues as a dark reaction even after the light is cut off.

In recent years, a wide variety of photo devices and electronic devices have been developed and produced, but since the viscosity of conventionally used slow-curing photocurable adhesives prior to irradiation with light is not low enough, it is difficult to apply them as a thin layer, and since their liquid state subsequent to irradiation with light cannot be maintained for long enough, it is difficult to carry out a complicated alignment.

It is therefore an object of the present invention to provide a slow-curing photocurable adhesive that has a low viscosity prior to irradiation with light, can maintain its liquid state (a state before reaching a gel point) subsequent to irradiation with light for a time required for alignment of adherends, etc., for example, 5 to 30 minutes, and has a sufficiently high viscosity at the gel point.

This object of the present invention has been attained by means (1) below.
(1) An actinic radiation curable adhesive comprising 50 to 99 wt % of a bifunctional and/or a polyfunctional oxetane compound (Component A), 0 to 40 wt % of a monofunctional oxetane compound (Component B), 1 to 50 wt % of an epoxy compound having a cyclic structure (Component C); and a catalytic amount of a photoinitiator, the adhesive having an initial viscosity of 10 to 1,000 mPa·s and a viscosity at gel point of 1 × 10¹ to 9 × 10⁶ Pa.s; and a bonding process employing same.
   Several preferred modes for implementing the adhesive related to above-mentioned (1), together with the bonding process employing same, are listed below.
(2) The actinic radiation curable adhesive according to (1), wherein the adhesive further comprises a photosensitizer or a silane coupling agent.
(3) The actinic radiation curable adhesive according to (1) or (2), wherein the adhesive is cured by irradiation with UV rays or visible light.
(4) The actinic radiation curable adhesive according to any one of (1) to (3), wherein the adhesive has a time t (gel) required for gelling of 2 to 30 minutes after irradiation with UV rays or 5 to 30 minutes after irradiation with visible light.
(5) The actinic radiation curable adhesive according to any one of (1) to (4), wherein Component B comprises a hydroxyl group-containing monofunctional oxetane compound.
(6) The actinic radiation curable adhesive according to any one of (1) to (5), wherein Component A comprises a bifunctional oxetane compound having, as a linking group located between the two oxetanyl groups, a phenylene group, a biphenylene group, a naphthalene group, a group in which two phenylene groups are bonded via a methylene group, or a binaphthalene group.
(7) A bonding process for bonding an adherend A and an adherend B, which is different from the adherend A, the process comprising a step of forming an adhesive layer by coating a surface of the adherend A with the actinic radiation curable adhesive according to any one of (1) to (6) at an adhesive thickness of 0.05 to 50 µm, a step of irradiating the adhesive layer with UV rays or visible light, and a step of bonding the adherend B to the adhesive layer after 0.01 to 4 times a time t (gel) required for gelling of the adhesive layer has passed following the start of the irradiation with actinic radiation.

The 'actinic radiation' referred to here includes radiation such as UV rays, visible light, an electron beam, and γ-rays, which can form active species that can initiate a curing reaction of a composition containing Components A, B, and C above and a photoinitiator. Hereinafter, an 'actinic radiation curable adhesive' may be called simply a 'photocurable adhesive'.

The photocurable adhesive of the present invention gives a sufficient working time required for positioning two adherends, even when bonding together adherends that are opaque to light. Furthermore, the photocurable adhesive of the present invention may be an adhesive that can give a high viscosity at gel point, and can reduce the amount of adhesive that is squeezed out from the interface between the two adherends when bonding them together.

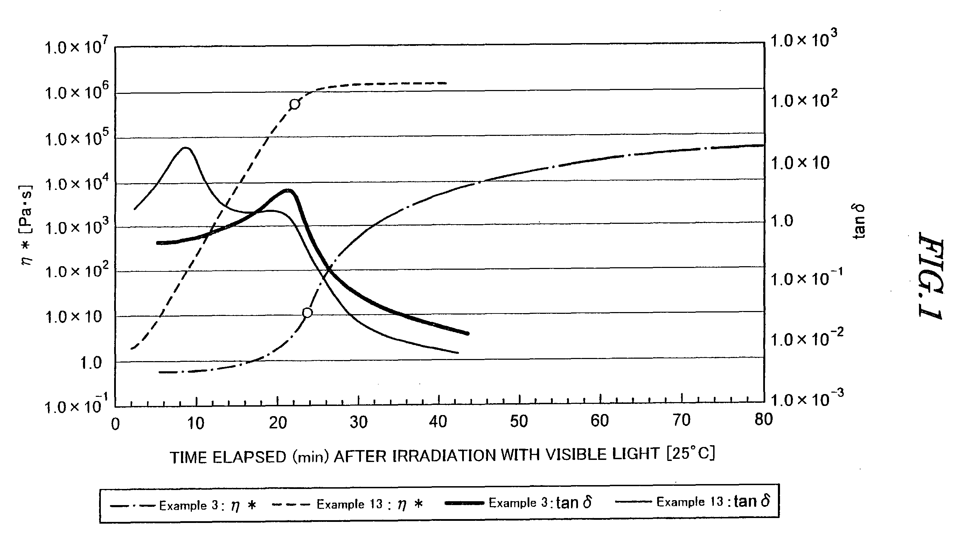

FIG. 1 shows one example of changes in dynamic viscoelasticity behavior over time during a curing reaction by irradiation of an actinic radiation curable adhesive of the present invention with light.

The photocurable adhesive of the present invention comprises 50 to 99 wt % of a bifunctional and/or a polyfunctional oxetane compound (Component A), 0 to 40 wt % of a monofunctional oxetane compound (Component B), 1 to 50 wt % of an epoxy compound having a cyclic structure (Component C), and a catalytic amount of a photoinitiator; its initial viscosity is 10 to 1,000 mPa·s, and its viscosity at gel point is 1 × 10¹ to 9 × 10⁶ Pa·s. When the bifunctional and the polyfunctional oxetane compound are used in combination as Component A, the above mixing ratio is the total amount thereof. In the present invention, the initial viscosity means the viscosity of the photocurable adhesive at a room temperature of 25°C prior to irradiation with light. The gel point means a point at which the storage modulus and the loss modulus intersect in a viscoelasticity measurement (tan δ = 1). The viscosity at gel point means the viscosity obtained at the gel point.

Components A, B, and C of the photocurable adhesive of the present invention, together with their mixing ratio, are explained below.

The photocurable adhesive used in the present invention includes 50 to 99 wt % of a bifunctional or polyfunctional oxetane compound (Component A), 0 to 40 wt % of a monofunctional oxetane compound (Component B), and 1 to 50 wt % of an epoxy compound having a cyclic structure (Component C). The total of Components A, B, and C is 100 wt %.

Component A is a bifunctional oxetane compound and/or a polyfunctional oxetane compound. The bifunctional oxetane compound means a compound having two oxetanyl groups in the molecule. The polyfunctional oxetane compound means a compound having on average more than two oxetanyl groups in the molecule.

In the present invention, as the bifunctional or polyfunctional oxetane compound, compounds represented by Formula (1) below are preferable

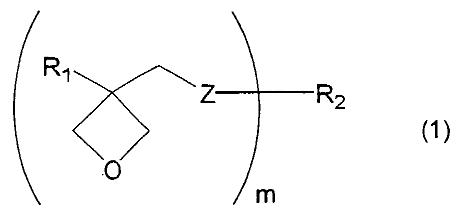

In Formula (1), m denotes an integer of 2, 3, or 4, and Z denotes an oxygen atom, a sulfur atom, or a selenium atom. R₁ denotes a hydrogen atom, a fluorine atom, a straight-chain or branched-chain alkyl group having 1 to 6 carbons, a fluoroalkyl group having 1 to 6 carbons, an allyl group, a phenyl group, or a furyl group. R₂ denotes an m-valent linking group, is preferably a group having 1 to 20 carbons, and may contain at least one oxygen or sulfur atom.

Z is preferably an oxygen atom, R₁ is preferably an ethyl group, m is preferably 2, 3, or 4, and more preferably 2, and R₂ is preferably a linear or branched alkylene group having 1 to 16 carbons, a linear or branched poly(alkyleneoxy) group, a phenylene group, 1,4-CH₂-C₆H₄-CH₂-, a biphenylene group, a group in which two phenylene groups are joined via a methylene group, a naphthalene group, a bisnaphthalene group, etc. A compound in which any two or more of the preferred examples of R₁, R₂, Z, and m are combined is more preferable.

Examples of the bifunctional oxetane compound that can be used as Component A include 1,4-bis{(3-ethyl-oxetanyl)methoxymethyl}benzene (XDO), 1,3-bis{(1-ethyl-3-oxetanyl)methoxy}benzene (RSOX), and 2,2'-bis{(3-ethyloxetanyl-3-yl)methoxy}biphenyl (2,2'-BPOX) manufactured by Toagosei Co., Ltd.

Furthermore, as Component A, bisoxetanes described in JP-A-2001-31664, which have a naphthalene group in the linking portion, can be used. Similarly, bisoxetanes described in JP-A-2001-31666, which contain a binaphthalene group in the linking portion, and bisoxetanes described in JP-A-2002-80581, which have bisphenol F and nuclear-substituted derivatives thereof as the linking portion, can also be used as Component A.

The bifunctional or polyfunctional oxetane compounds used as Component A in the present invention may be used singly or in a combination of two or more types.

The bifunctional or polyfunctional oxetane compound (Component A) is a main component of the adhesive of the present invention, imparts living polymerization properties, and imparts a required strength to the adhesive after curing.

The content of Component A is preferably 60 to 98 wt %, and more preferably 70 to 98 wt %, relative to the total amount of Components A to C.

Component B is a monofunctional oxetane compound. The monofunctional oxetane compound means a compound having one oxetanyl group in the molecule.

In the present invention, as the monofunctional oxetane compound, compounds represented by Formula (2) below are preferable.

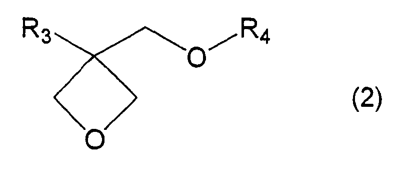

In Formula (2), R₃ denotes a methyl group or an ethyl group. R₄ denotes a hydrogen atom or a hydrocarbon group having 1 to 12 carbons.

With regard to the hydrocarbon group represented by R₄, a phenyl group, a benzyl group, a naphthalene group, or an alkyl group is preferable. With regard to the alkyl group, an alkyl group having 6 to 8 carbons is preferable, and a branched alkyl group such as 2-ethylhexyl is particularly preferable. Examples of the oxetane compound in which R₄ is a phenyl group are described in JP-A-11-140279. Examples of the oxetane compound in which R₄ is a benzyl group, which may be substituted, are described in JP-A-6-16804.

The monofunctional oxetane compounds that can be used as Component B are commercially available and examples thereof include 3-ethyl-3-(2-ethylcyclohexylmethyl)oxetane (EHOX), 3-ethyl-3-(phenoxymethyl)oxetane (POX), and 3-ethyl-3-(hydroxymethyl)oxetane (OXA) manufactured by Toagosei Co., Ltd.

The monofunctional oxetane compounds used in the present invention may be used singly or in a combination of two or more types.

The content of Component B is preferably 0 to 30 wt %, and more preferably 0 to 20 wt %, relative to the total amount of Components A to C.

Although monofunctional oxetane compounds (Component B) are cationically polymerizable, since they have a lower viscosity than that of Component A, the addition thereof is effective in reducing the viscosity of the adhesive. In general, it is unnecessary for the content thereof to exceed 40 wt % in order for there to be a dilution effect. When the content is too large, the strength of the adhesive after curing tends to be degraded.

When a monofunctional oxetane where R₄ in Formula (2) is a hydrogen atom is added, it is effective in increasing the time required for gelling (hereinafter, also expressed as 't (gel)', and also called 'gel point time'). The effect is apparent when the content is about 5 wt %, and a content of about 10 wt % is appropriate in many cases.

Component C is an epoxy compound. This epoxy compound preferably has a cyclic structure in a portion other than the epoxy group, and may be a monofunctional epoxy compound or a bi- or higher-functional epoxy compound.

In the present invention, in order to enhance the slow-curing properties, a 'standard epoxy compound' having a relatively low reaction rate can be used preferably as Component C. The 'standard epoxy compound' means an epoxy compound that has no alicyclic epoxy group having a partial structure obtained by epoxidizing, with an oxidizing agent such as a peracid, the double bond of a cycloalkene ring such as a cyclopentene group or a cyclohexene group.

The monofunctional or bi- or higher-functional standard epoxy compound preferably has at least one cyclic structure in the compound. The cyclic structure referred to here means a ring other than an oxirane ring, and examples thereof include an aromatic group and a cycloalkyl group.

Specific examples of the epoxy compound having a cyclic structure include aromatic glycidyl ether compounds such as 1,3-bis(2,3-epoxypropyloxy)benzene, a bisphenol A epoxy resin, a bisphenol F epoxy resin, a phenol-novolac epoxy resin, a cresol-novolac epoxy resin, and a trisphenolmethane epoxy resin. In the present invention, a bisphenol F epoxy resin can be used preferably. These epoxy compounds are commercially available from Daicel Chemical Industries, Ltd., Dainippon Ink and Chemicals, Inc., etc.

In the present invention, the epoxy compound (Component C) may be used singly or in a combination of two or more types.

By adding Component C to Component A and Component B, the curing rate of the adhesive can be increased.

The content of Component C is preferably 2 to 40 wt %, and more preferably 5 to 30 wt %, relative to the total amount of Components A to C.

When an epoxy compound having an alicyclic epoxy group is added, the curing rate tends to become too high, and it is not very suitable for use as Component C of the present invention.

It is necessary for the photocurable adhesive used in the present invention to contain a photoinitiator that, by irradiation with actinic radiation (hereinafter, also simply called 'light') such as UV rays or visible light, generates an active species that initiates cationic polymerization. It is also possible to use an electron beam as the actinic radiation.

As the photoinitiator, an onium salt that can generate an active species that can initiate a curing reaction by the action of absorbed light is used preferably. It is thought that the onium salt photoinitiator itself absorbs light and is excited, or is excited when a photosensitizer that is present at the same time absorbs light to become an excited photosensitizer and energy is transferred therefrom to the photoinitiator, thus generating an active chemical species. As the onium salt photoinitiator, an aromatic iodonium salt, an aromatic sulfonium salt, etc. are preferable since they are relatively stable toward heat. As light that generates the active chemical species from the onium salt, UV rays having a wavelength of 300 nm to less than 390 nm and visible light having a wavelength of 390 nm to 500 nm are preferable.

The photoinitiator can be used in a catalytic amount, and the amount thereof added is usually 0.1 to 10 parts by weight, and preferably 0.1 to 6 parts by weight, relative to a total of 100 parts by weight of Components A to C.

The chemical structure of the photoinitiator is explained in detail below.

When an aromatic sulfonium salt or an aromatic iodonium salt is used as the photoinitiator, as a counter anion therefor, BF₄⁻ , AsF₆⁻, SbF₆⁻, PF₆⁻, B(C₆F₅)₄⁻, etc. can be cited. As the initiator, an aromatic sulfonium PF₆ or SbF₆ salt can be used preferably since these salts have solubility and appropriate polymerization activity. In order to improve the solubility, it is preferable to employ a chemical structure in which at least one alkyl or alkoxy group having 1 to 10 carbons is introduced into an aromatic group, usually a phenyl group, of the aromatic iodonium salt or the aromatic sulfonium salt.

Aromatic sulfonium PF₆ and SbF₆ salts are commercially available from Union Carbide Japan K.K., etc. Aromatic sulfonium PF₆ salts are also commercially available from Asahi Denka Co., Ltd. as the Adeka Optomer SP series. Aromatic sulfonium PF₆ salts are also commercially available from Nippon Soda as the 'CI series' cationic polymerization initiators.

Among the structural formulae below, Sulfonium salts PI-3 and PI-4 are preferably used in the present invention.

lodonium salts denoted by PI-11 to PI-13 are described in JP-A-2002-302507.

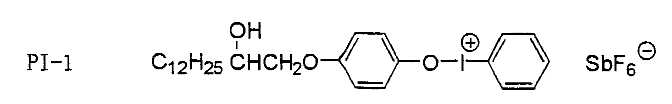

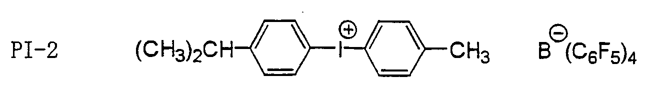

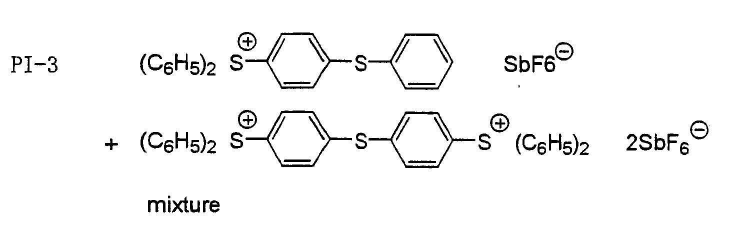

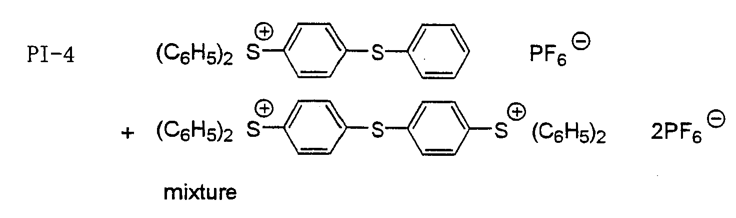

lodonium salts preferably used in the adhesive of the present invention are illustrated below as examples. In addition thereto, iodonium salt compounds described in JP-A-2002-302507 can also be used as the photoinitiator of the present invention.

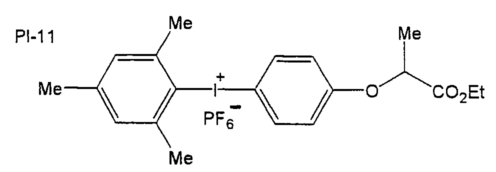

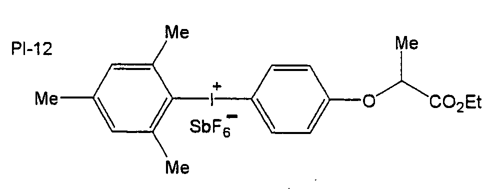

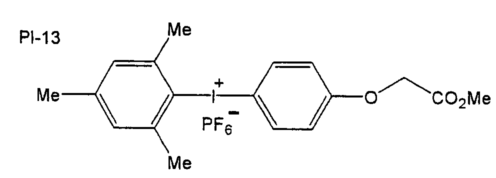

In the formulae, Et denotes an ethyl group, and Me denotes a methyl group.

### Photosensitizer

The photocurable adhesive used in the present invention may contain a photosensitizer as necessary in order to increase the activity of the photoinitiator.

The photosensitizer is a compound that makes a photocurable adhesive containing an onium salt photoinitiator curable by visible light, and preferably visible light in the region of 390 to 500 nm. It can be surmised that light energy absorbed by this photosensitizer is transferred to the photoinitiator, which is present at the same time, thus making the photoinitiator generate a cationic species and/or a radical cationic species for initiating a curing reaction. As another initiation mechanism, it can be surmised that the photosensitizer in an excited state generates an active chemical species, which generates a reaction-initiating species of the photoinitiator.

The photosensitizers used preferably in the present invention are thioxanthones, acetophenones, benzophenones, and 9,10-dialkoxyanthracenes, which have absorption at 390 to 500 nm, and 9,10-dialkoxyanthracenes are particularly preferable. Specific examples of these compounds are described in JP-A-11-322952. It is also possible to use compounds of Formula (I) described in JP-A-2002-302507.

When the above-mentioned photosensitizer is used, it may be used in an amount that is sufficient to absorb visible light at 390 to 500 nm and initiate a curing reaction of the adhesive, and the amount thereof added is usually 0.1 to 10 parts by weight, and preferably 0.1 to 5 parts by weight, relative to a total of 100 parts by weight of Components A to C.

Specific examples of the photosensitizer of the present invention are illustrated below.

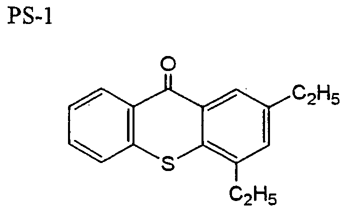

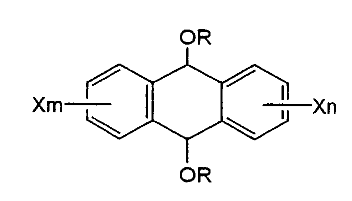

| | | |
|---|---|---|
| PS-2 | R = 2-Ethylhexyl | X = H |
| PS-3 | R = *n*-Dodecyl | X = H |
| PS-4 | R = Ethyl | X = 2-Ethyl |
| PS-5 | R = Ethyl | X = H |

### Silane coupling agent

The actinic radiation curable adhesive of the present invention may further contain a silane coupling agent as necessary.

It is thought that the silane coupling agent has the property of chemically bonding an adherend and the adhesive. By the concomitant use of the silane coupling agent it is possible to improve the adhesion strength and adhesion durability. With regard to the silane coupling agent used concomitantly in the present invention, an epoxysilane having an epoxy group and a triethoxysilyl group in the molecule is preferably used. Such a coupling agent is commercially available from Shin-Etsu Chemical Co., Ltd. as KBM403, KBM303, KBM402, etc. The amount of silane coupling agent added is 0.1 to 10 parts by weight, and preferably 0.1 to 3 parts by weight, relative to a total of 100 parts by weight of Components A to C.

The adhesive of the present invention has an initial viscosity prior to irradiation with actinic radiation of 10 to 1,000 mPa·s. When the viscosity is less than 10 mPa·s, the adhesive tends to flow when being applied on an adherend, and when the viscosity exceeds 1,000 mPa·s, it tends to be difficult to uniformly coat an adherend with the adhesive.

In the present invention, the initial viscosity is measured at a room temperature of 25°C using a Model VAR-100 viscoanalyzer (manufactured by Jasco International Co., Ltd.). The measurement is carried out by sandwiching the adhesive between an aluminum disc (diameter 30 mm) and a quartz glass disc at a thickness of 300 µm, and measuring the complex modulus of viscosity η* in oscillation strain control measurement mode (frequency 1 Hz, strain 30%).

The adhesive of the present invention has a viscosity at gel point obtained by measuring by the method below of 1 × 10¹ to 9 × 10⁶ Pa·s. When the viscosity at gel point is in this range, the amount of adhesive squeezed out between two adherends when they are bonded together can be reduced, and required adhesion strength can be obtained when a curing reaction is completed.

For the actinic radiation curable adhesive of the present invention, the time required for it to reach gel point after it is irradiated with UV rays or visible light, that is, a gel point time t (gel), is preferably 2 to 30 minutes in the case of UV rays or 5 to 30 minutes in the case of visible light.

The t (gel) can be measured by a viscoelasticity measurement described below.

The viscoelasticity measurement is carried out at a room temperature of 25°C using a Model VAR-100 viscoanalyzer. An adhesive layer is formed by coating quartz glass with the adhesive at a thickness of about 12 µm. The photocurable adhesive is irradiated with a mercury lamp light source via a UV cut-off filter and quartz glass. After the irradiation, an aluminum plate having a diameter of 6 mm is quickly pressed down on the adhesive layer so as to sandwich the adhesive layer between the quartz glass and the aluminum plate so that the thickness for measurement of the adhesive layer becomes 10 µm, and a viscoelasticity measurement is started. The complex modulus of viscosity η* and tan δ are measured in oscillation strain control measurement mode (frequency 1 Hz, maximum strain 5%). The progress of curing of the adhesive after irradiation can be followed by the viscoelasticity measurement. Measurement conditions are explained in detail below.

Since the photocurable adhesive of the present invention has an initial viscosity of 1,000 mPa·s or less, an adhesive layer can be easily formed with a small thickness of about 10 µm. After the adhesive layer is formed on quartz glass using a coating bar, etc., the adhesive layer is irradiated with UV rays or visible light.

In the case of UV rays, a UV spot light source (L5662-01; manufactured by Hamamatsu Photonics K.K.) is used, its irradiation strength is measured using a UV power meter (C6080-03; manufactured by Hamamatsu Photonics K.K.), and it is adjusted so as to be 100 mW/cm² at a position where the UV rays have passed through the quartz glass. In the case of visible light, a GG385 UV cut-off filter (manufactured by Schott Nippon K.K.) is disposed between a single light guide of the spot light source and the quartz glass.

FIG. 1 shows one example of the results of measurement of dynamic viscoelasticity.

In FIG. 1, the abscissa denotes the time elapsed (minutes) after starting irradiation with visible light, the left ordinate denotes the complex modulus of viscosity η* with an exponential scale, and the right ordinate denotes tan δ with an exponential scale. The complex modulus of viscosity increases steadily with respect to the elapse of time, and the white circle on the curve denotes the gel point. This gel point corresponds to an intersection between the storage modulus and the loss modulus as defined by ASTM D4473, that is, tan δ = 1. The elapse of time from starting the irradiation with light up to the white circle is the gel point time t (gel).

FIG. 1 shows the results for adhesives of Example 3 and Example 13.

The photocurable adhesive layer described above is irradiated with UV rays or visible light from the light source, and the gel point time t (gel) obtained by the above-mentioned viscoelasticity measurement at 25°C is preferably 2 to 30 minutes in the case of UV rays or 5 to 30 minutes in the case of visible light.

When the photocurable adhesive has a gel point time in the above-mentioned range, it is possible to ensure that, after an adhesive layer is formed on one adherend and is irradiated with light for an appropriate period of time so as to initiate a curing reaction, there is time for bonding another light-opaque adherend and carrying out a required alignment.

The curing reaction of the photocurable adhesive of the present invention is initiated by irradiation with actinic radiation such as UV rays or visible light. After irradiating with light for a predetermined period of time, the curing reaction continues by a dark reaction even if the light is cut off, and the curing reaction is completed as time elapses. The light irradiation time required for the curing reaction to continue as a dark reaction depends on the mixing ratio of Components A, B, and C, but in general the gel point time becomes long when the light irradiation time is short, and the gel point time becomes short when the light irradiation time is long.

The bonding process of the present invention is a process for bonding adherend A to a different adherend B, and comprises a step of coating adherend A with the above-mentioned photocurable adhesive at an adhesive thickness of 0.05 to 50 µm, a step of irradiating the adhesive with UV rays or visible light, and a step of bonding adherend B to the adhesive layer after 0.01 to 4 times the time t (gel) required for gelling of the adhesive layer has passed following the start of irradiation with actinic radiation.

In the coating step, the thickness of the adhesive is preferably 0.1 to 30 µm, and particularly preferably 0.5 to 15 µm.

The bonding step is preferably carried out after 0.1 to 2 times the time t (gel) has passed following the start of irradiation with actinic radiation, and more preferably after 0.2 to 1.0 times the time t (gel) has passed.

After the bonding step, alignment of the two adherends A and B is carried out as required.

After the alignment is completed, the two adherends are fixed and, as necessary, compression bonded.

As hereinbefore described, a curing reaction is started in the actinic radiation curable adhesive of the present invention by irradiation with actinic radiation, and the curing reaction continues thermally as a dark reaction even after the irradiation with actinic radiation is cut off. The adhesive of the present invention can therefore be suitably used even for bonding adherends that are opaque to light.

Materials used in Examples of the present invention are summarized in Table 1. The structural formulae thereof are also shown below.

**(Table 1)**

| Abbreviation | Type | Chemical Structure | Manufacturer |
|---|---|---|---|
| EHOX | Monofunctional oxetane | Cpd-1 | Toagosei Co., Ltd. |
| POX | Monofunctional oxetane | Cpd-2 | Toagosei Co., Ltd. |
| OXA | Monofunctional oxetane | Cpd-3 | Toagosei Co., Ltd. |
| XDO | Bifunctional oxetane | Cpd-4 | Toagosei Co., Ltd. |
| RSOX | Bifunctional oxetane | Cpd-5 | Toagosei Co., Ltd. |
| 2,2'-BPOX | Bifunctional oxetane | Cpd-6 | Toagosei Co., Ltd. |
| EXA830LVP | Bisphenol F epoxy resin | Cpd-7 | Dainippon Ink and Chemicals, Inc. |
| AOEX24 | Monofunctional epoxy | Cpd-8 | Daicel Chemical Industries, Ltd. |
| UVI-6992 | Photoinitiator | Cpd-9 | Dow Chemical Japan |
| CI-5102 | Photoinitiator | Cpd-10 | Nippon Soda |
| SP100 | Photosensitizer | | Asahi Denka Co., Ltd. |
| CS-7102 | Photosensitizer | | Nippon Soda |
| KBM403 | Silane coupling agent | Cpd-11 | Shin-Etsu Chemical Co., Ltd. |

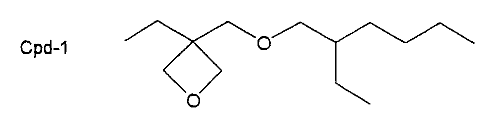

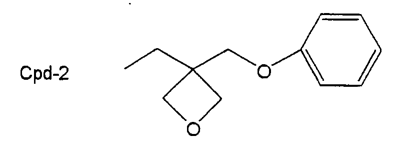

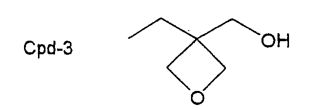

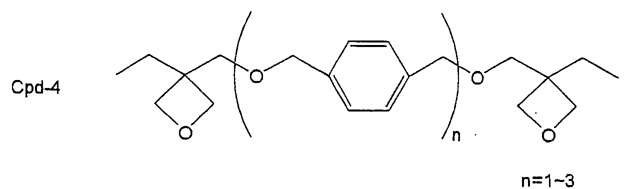

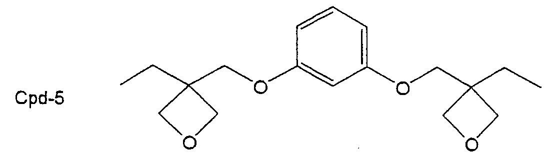

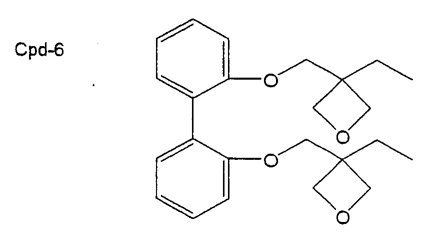

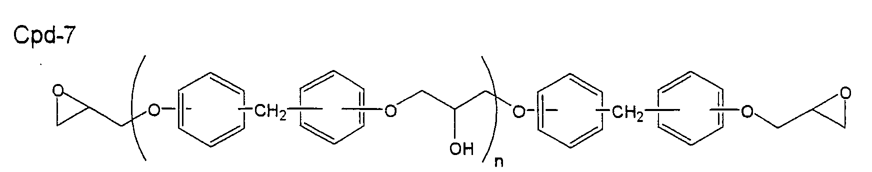

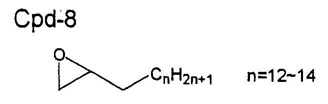

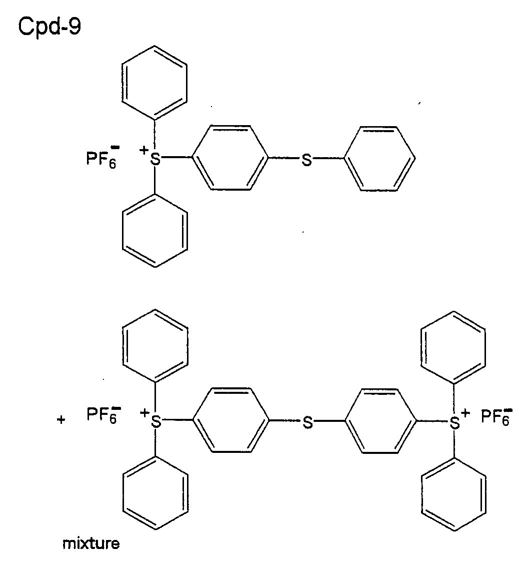

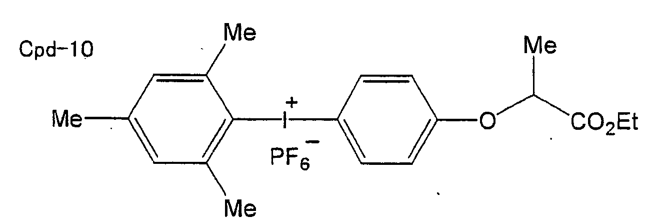

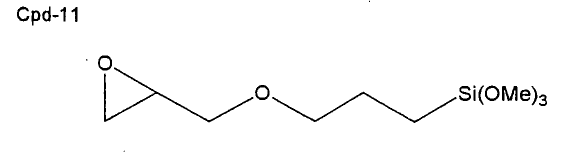

### Measurement of Curing Profile by Dynamic Viscoelasticity

Measurement was carried out using a Model VAR-100 viscoanalyzer (manufactured by Jasco International Co., Ltd.) with parallel plate measurement geometry. As the parallel plates, a quartz glass plate and an aluminum plate (diameter 6 mm) were used.

The quartz glass plate was firstly bar-coated with an adhesive at a thickness of 10 to 13 µm using a D-Bar (manufactured by OSG Corp.).

Subsequently, the adhesive was irradiated with UV light or visible light through the quartz glass plate for a fixed period of time. For the UV light, a UV spot light source (L5662-01, manufactured by Hamamatsu Photonics K.K.) was used, and the irradiation strength after having passed through the quartz glass plate was adjusted to 100 mW/cm² using a C6080-03 UV power meter (manufactured by Hamamatsu Photonics K.K.). Visible light was obtained by arranging a GG385 UV cut-off filter (manufactured by Schott Nippon K.K.) between a single light guide of the spot light source and the quartz parallel glass.

After the irradiation with light, the adhesive was sandwiched quickly between the aluminum plate and the quartz glass plate with a gap of 10 µm, and measurement was started.

The measurement temperature was 25°C, the measurement mode was oscillation strain control (frequency = 1 Hz, strain = 5% (Max), etc.), and the complex modulus of viscosity η* and tan δ were measured.

The gel point was an intersection (tan δ = 1) between the storage modulus and the loss modulus as defined by ASTM D4473, and the viscosity at that point was defined as the viscosity at gel point. The time elapsed from the start of irradiation with light to the gel point was defined as the gel point time.

### Examples 1 and 2

Adhesives of Examples 1 and 2 and Comparative Examples 1 to 3 had compositions shown in Table 2 below, and are shown together with the results for the gel point time and the viscosity at gel point. Irradiation was with visible light in all cases.

**(Table 2)**

| Component | Example 1 | Example 2 | Comparative Example 1 | Comparative Example 2 | Comparative Example 3 |
|---|---|---|---|---|---|
| EXA830LVP | 5 | 10 | 90 | 90 | 100 |
| XDO | 95 | 90 | | | |
| EHOX | | | 10 | | |
| AOEX24 | | | | 10 | |
| UVI-6992 | 4 | 4 | 4 | 4 | 4 |
| SP100 | 1 | 1 | 1 | 1 | 1 |
| KBM403 | 3 | 3 | 3 | 3 | 3 |
| Initial viscosity (mPa·s) | 180 | 200 | 370 | 370 | 740 |
| Light irradiation conditions | Visible light - 60 s visible light - 60 s | | | | |
| Gel point time (min) | 16 | 9 | 4 | 4 | 3 |
| Viscosity at gel point (Pa·s) | 22 | 36 | 1.2 × 10⁵ | 9.2 × 10⁴ | 1.3 × 10⁵ |

The Comparative Examples had compositions having a bisphenol F epoxy resin as the main component; the viscosity at gel point was high, but the gel point time was short.

The Examples had compositions having a bifunctional oxetane as the main component; the gel point time was at least twice that of the Comparative Examples, but the viscosity at gel point was on the order of 10 Pa. s.

### Examples 3 to 5

Adhesives of Examples 3 to 5 were mixed as shown in Table 3 below, and are shown together with the results for the gel point time and the viscosity at gel point. Irradiation was with visible light in all cases.

**(Table 3)**

| Composition | Example 3 | Example 4 | Example 5 |
|---|---|---|---|
| EXA830LVP | 10 | 10 | 20 |
| XDO | 80 | 80 | 70 |
| EHOX | 10 | 10 | 10 |
| CI-5102 | 4 | 6 | 4 |
| CS-7102 | 1 | 2 | 1 |
| KBM403 | 3 | 3 | 3 |
| Initial viscosity (mPa·s) | 130 | 130 | 150 |
| Light irradiation conditions | Visible light - 60 s | | |
| Gel point time (min) | 24 | 9 | 10 |
| Viscosity at gel point (Pa.s) | 10 | 17 | 16 |

The photoinitiator and the photosensitizer were changed from those in Table 2. When the amount added was increased, the gel point time became short.

When the proportion of EXA830LVP added was increased, the gel point time became short. In all cases, in this range of addition the viscosity at gel point became somewhat greater.

### Examples 3, 6, and 7

Example 3 was repeated, and new adhesives of Examples 6 and 7 were mixed as shown in Table 4; they are shown together with the results for the gel point time and the viscosity at gel point. Irradiation was with visible light in all cases.

**(Table 4)**

| Composition | Example 3 | Example 6 | Example 7 |
|---|---|---|---|
| EXA830LVP | 10 | 10 | 10 |
| XDO | 80 | | |
| RSOX | | 70 | 70 |
| EHOX | 10 | 20 | 20 |
| CI-5102 | 4 | 4 | |
| CS-7102 | 1 | 1 | |
| UVI-6992 | | | 4 |
| SP100 | | | 1 |
| KBM403 | 3 | 3 | 3 |
| Initial viscosity (mPa·s) | 130 | 200 | 200 |
| Light irradiation conditions | Visible light - 60 s | | |
| Gel point time (min) | 24 | 12 | 10 |
| Viscosity at gel point (Pa·s) | 10 | 1.5 × 10² | 1.3 × 10² |

When XDO was changed to RSOX, the gel point time became short, but the viscosity at gel point increased at least 10 times.

With regard to the combination of photoinitiator and photosensitizer, the gel point time was longer for CI-5102/CS7102 than for UVI6992/SP100.

### Examples 8 to 13

Adhesives of Example 8 to 13 were mixed as shown in Table 5 below, and are shown together with the results for the gel point time and the viscosity at gel point. Irradiation was with visible light in all cases.

**(Table 5)**

| Composition | Example 8 | Example 9 | Example 10 | Example 11 | Example 12 | Example 13 |
|---|---|---|---|---|---|---|
| EXA830LVP | 10 | 21 | 21 | 5 | 15 | 10 |
| 2,2'-BPOX | 70 | 70 | 61 | 75 | 66 | 70 |
| EHOX | 20 | | | 20 | | |
| POX | | | 9 | | 9 | 15 |
| OXA | | 9 | 9 | | 10 | 5 |
| CI-5102 | 4 | 4 | 4 | 4 | 4 | 4 |
| CS-7102 | 1 | 1 | 1 | 1 | 1 | 1 |
| KBM403 | 3 | 3 | 3 | 3 | 3 | 3 |
| Initial viscosity (mPa·s) | 170 | 730 | 390 | 150 | 350 | 330 |
| Light irradiation conditions | Visible light - 60 s | | | | | |
| Gel point time(min) | 7 | 13 | 14 | 16 | 24 | 22 |
| Viscosity at gel point (Pa·s) | 2.9 × 10⁵ | 4.0 × 10⁵ | 3.8 × 10⁵ | 2.4 × 10⁵ | 6.6 × 10⁵ | 5.0 × 10⁵ |

When 2,2'-BPOX was used as the bifunctional oxetane instead of RSOX, the gel point time became short, but the viscosity at gel point increased at least 1,000 times.

When the amount of EXA830LVP was decreased, the viscosity at gel point did not change greatly, but the gel point time increased.

When the monofunctional oxetane OXA was added, the viscosity at gel point did not change greatly, but the gel point time increased.

### Examples 14 and 15

New adhesives of Example 14 and Example 15, and re-tests of the adhesives of Examples 8 and 10 were prepared as shown in Table 6, and are shown together with the results for the gel point time and the viscosity at gel point. Irradiation was with visible light and UV light.

**(Table 6)**

| Composition | Example 10 | Example 14 | Example 8 | Example 15 |
|---|---|---|---|---|
| EXA830LVP | 21 | | 10 | |
| 2,2'-BPOX | 61 | | 70 | |
| EHOX | | | 20 | |
| POX | 9 | | | |
| OXA | 9 | | | |
| CI-5102 | 4 | | 4 | |
| CS-7102 | 1 | | 1 | |
| KBM403 | 3 | | 3 | |
| Initial viscosity (mPa·s) | 390 | | 170 | |
| Light irradiation conditions | Visible light - 60 s | UV light - 10 s | Visible light - 60 s | UV light - 10 s |
| Gel point time (min) | 14 | 8 | 7 | 3 |
| Viscosity at gel point (Pa·s) | 3.8 × 10⁵ | 6.4 × 10⁵ | 2.9 × 10⁵ | 3.9 × 10⁵ |

When comparing visible light and UV light, visible light gave a longer gel point time. The viscosity at gel point did not vary greatly.

### Comparative Example 5

For reference purposes, a commercial product (for bonding a DVD) was tested in the same manner as in Example 1, and results for the gel point time and the viscosity at gel point are shown in Table 7. Irradiation was with UV light for 5 seconds. It was found that this commercial product had a short gel point time.

**(Table 7)**

| Commercial product | Daicure Clear EX4020 |
|---|---|
| Dainippon Ink and Chemicals, Inc. | |
| Initial viscosity (mPa·s) | 300 |
| Light irradiation conditions | UV-5s |
| Gel point time (min) | 2 |
| Viscosity at gel point (Pa.s) | 3.2 × 10³ |

The present invention can be applied to the production of various types of photo devices and electronic devices. In particular, since it can be desirably used for mounting a CCD, it is useful for the production of digital cameras and camera-equipped cellular phones.

## Claims

1. An actinic radiation curable adhesive comprising:
50 to 99 wt % of a bifunctional and/or a polyfunctional oxetane compound (Component A);
0 to 40 wt % of a monofunctional oxetane compound (Component B);
1 to 50 wt % of an epoxy compound having a cyclic structure (Component C); and
a catalytic amount of a photoinitiator;
the adhesive having an initial viscosity of 10 to 1,000 mPa·s and a viscosity at gel point of 1 × 10¹ to 9 × 10⁶ Pa·s.

2. The actinic radiation curable adhesive according to Claim 1, wherein the adhesive further comprises a photosensitizer or a silane coupling agent.

3. The actinic radiation curable adhesive according to either Claim 1 or Claim 2, wherein the adhesive is cured by irradiation with UV rays or visible light as the actinic radiation.

4. The actinic radiation curable adhesive according to any one of Claim 1 to Claim 3, wherein the adhesive has a time t (gel) required for gelling of 2 to 30 minutes after irradiation with UV rays as the actinic radiation or 5 to 30 minutes after irradiation with visible light as the actinic radiation.

5. The actinic radiation curable adhesive according to any one of Claim 1 to Claim 4, wherein the bifunctional and/or the polyfunctional oxetane compound (Component A) comprises a compound represented by Formula (1) 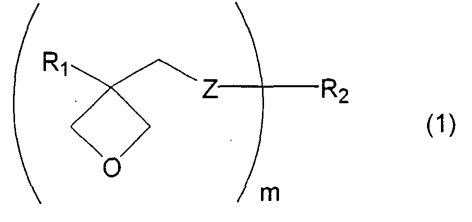 wherein m denotes an integer of 2, 3, or 4, Z denotes an oxygen atom, a sulfur atom, or a selenium atom, R₁ denotes a hydrogen atom, a fluorine atom, a straight-chain or branched-chain alkyl group having 1 to 6 carbons, a fluoroalkyl group having 1 to 6 carbons, an allyl group, a phenyl group, or a furyl group, and R₂ denotes an m-valent linking group that may contain at least one oxygen or sulfur atom.

6. The actinic radiation curable adhesive according to any one of Claim 1 to Claim 5, wherein the bifunctional and/or the polyfunctional oxetane compound (Component A) comprises a bifunctional oxetane compound having, as a linking group located between the two oxetanyl groups, a phenylene group, a biphenylene group, a naphthalene group, a group in which two phenylene groups are bonded via a methylene group, or a binaphthalene group.

7. The actinic radiation curable adhesive according to any one of Claim 1 to Claim 6, wherein the monofunctional oxetane compound (Component B) comprises a compound represented by Formula (2) 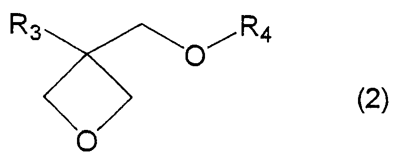 wherein R₃ denotes a methyl group or an ethyl group, and R₄ denotes a hydrogen atom or a hydrocarbon group having 1 to 12 carbons.

8. The actinic radiation curable adhesive according to any one of Claim 1 to Claim 7, wherein the monofunctional oxetane compound (Component B) comprises a hydroxyl group-containing monofunctional oxetane compound.

9. The actinic radiation curable adhesive according to any one of Claim 1 to Claim 8, wherein the epoxy compound having a cyclic structure (Component C) comprises a compound in which the cyclic structure is an aromatic group or a cycloalkyl group.

10. A bonding process for bonding an adherend A and an adherend B, which is different from adherend A, the process comprising:
a step of forming an adhesive layer by coating a surface of the adherend A with the actinic radiation curable adhesive according to any one of Claim 1 to Claim 9 at an adhesive thickness of 0.05 to 50 µm;
a step of irradiating the adhesive layer with actinic radiation; and
a step of bonding the adherend B to the adhesive layer after 0.01 to 4 times a time t (gel) required for gelling of the adhesive layer has passed following the start of the irradiation with actinic radiation.
